# EUROPÄISCHE PATENTSCHRIFT

(11) **EP 1 598 660 B1**
(45) Veröffentlichungstag und Bekanntmachung des Hinweises auf die Patenterteilung: **13.12.2006**
(21) Anmeldenummer: 04012165.9
(22) Anmeldetag: 22.05.2004
(51) Int. Cl.: G01N 21/86, C23C 14/54, C23C 14/56

(54) **Beschichtungsanlage mit einer Messvorrichtung für die Messung von optischen Eigenschaften von beschichteten Substraten**
Coating installation with a measuring device for measuring the optical characteristics of coated substrates
Installation de revêtement avec un dispositif de mesure servant à mesurer les caractéristiques optiques des substrats revêtus

(43) Veröffentlichungstag der Anmeldung: 23.11.2005
(73) Patentinhaber: Applied Materials GmbH & Co. KG, 63755 Alzenau (DE)
(72) Erfinder: Lotz, Hans-Georg, 63584 Gründau-Rothenbergen (DE); Sauer, Peter, 36381 Schlüchtern (DE); Hein, Stefan, 63825 Blankenbach (DE); Skuk, Peter, 61130 Nidderau (DE)
(74) Vertreter: Schickedanz, Willi

(56) Entgegenhaltungen:
- DE-A- 2 225 946
- DE-C- 922 596
- DE-C- 10 019 258
- RU-C1- 2 087 861
- SU-A2- 952 373
- US-A- 4 693 803

## Beschreibung

Beschichtete Substrate, beispielsweise beschichtete Architekturgläser oder beschichtete Kunststofffolien, weisen nach ihrer Beschichtung geänderte optische Eigenschaften auf. Ob diese optischen Eigenschaften den gewünschten Eigenschaften entsprechen, kann durch entsprechende Messungen festgestellt werden. Eine nachträgliche Feststellung der optischen Eigenschaften, d. h. wenn sich bereits eine oder mehrere Schichten auf dem Substrat befinden, kann nur noch den Zweck erfüllen, die guten Beschichtungen von den schlechten zu trennen. Man ist deshalb bestrebt, die optischen Eigenschaften möglichst schon während des Beschichtungsvorgangs zu erfassen, um gegebenenfalls in den Beschichtungsvorgang selbst eingreifen zu können.

Es ist bereits eine Spektralfotometeranordnung bekannt, mit der unter Beibehaltung der Messgenauigkeit mit einem einzigen Mess- und Auswertesystem eine größere Zahl von Messobjekten innerhalb einer geschlossenen Kammer erfasst werden kann (DE 34 06 645 C2). Hierbei werden mehrere Messstellen, die in einer geschlossenen Kammer untergebracht sind, durch mehrere Glasfaserkabel auf eine Lichtzerlegungseinrichtung aufgeschaltet. Durch eine zugehörige bewegliche Blende können mit dieser einzigen Lichtzerlegungseinrichtung und einer nachgeschalteten Auswerteschaltung eine praktisch beliebige Zahl von Messstellen bzw. Messobjekten erfasst und die dort erhaltenen Messergebnisse ausgewertet werden.

Diese Fotometeranordnung ist indessen für die Inline-Messung von zu beschichtenden Substraten, die mehrere Kammern durchlaufen, nicht geeignet.

Weiterhin ist eine Vorrichtung zur Herstellung geschichteter Übertragungsleitungen bekannt, bei der eine Kabelseele durch vier verschiedene Arten von Kammern nacheinander hindurchgeführt wird (DE 922 596). Es handelt sich hierbei um eine Metallverdampfungskammer, Metalldickensteuerkammer, Isoliermaterialverdampfungskammer und Isolierschichtdickensteuerkammer. Die Steuerkammern dienen zur Feststellung der Dicke einer Dielektrikumschicht. Dabei wird ein Steuersignal durch einen gebündelten Lichtstrahl erzeugt, der von einer geeigneten Lichtquelle ausgeht und über ein optisches System auf die Dielektrikumschicht fällt. Der von dieser Schicht reflektierte Strahl wird über ein geeignetes optisches System auf eine Fotozelle gerichtet. Die aus Lichtquelle, optischem System und Fotozelle bestehende Messvorrichtung ist dabei über eine ganze Kammer verteilt.

Bei einem anderen bekannten Verfahren zur Vakuumbeschichtung bandförmiger transparenter Substrate wird ein Substrat mindestens einmal mit einer Reflexionsschicht und anschließend mit mindestens einer transparenten Schicht beschichtet (DE 100 19 258 C1). Während oder nach der Beschichtung mit der transparenten Schicht wird reflektiertes Licht gemessen, um Informationen über die transparente Schicht zu erhalten, mit deren Hilfe Prozessparameter angepasst und/oder Schichtparameter kontrolliert werden. Die Messvorrichtung für das reflektierte Licht befindet sich dabei außerhalb einer Beschichtungskammer und ist gegenüber dem bandförmigen Substrat angeordnet.

Der Erfindung liegt die Aufgabe zugrunde, in Beschichtungsanlagen, die aus mehreren Kammern bestehen, die optischen Eigenschaften von beschichteten Substraten auch während des Beschichtungsvorgangs zu messen.

Diese Aufgabe wird gemäß den Merkmalen des Patentanspruchs 1 gelöst.

Die Erfindung betrifft somit eine Beschichtungsanlage zum Beschichten eines Substrats, mit mehreren hintereinander angeordneten Beschichtungskammern, Trennwänden zwischen den Beschichtungskammern, wobei das jeweils freie Ende der Trennwände dicht über dem Substrat angeordnet ist, das von einer Beschichtungskammer in die nächste Beschichtungskammer transportiert wird, und mit einer Messvorrichtung für die Messung von optischen Eigenschaften von beschichteten Substraten, wobei die Messvorrichtung jeweils an den freien Enden der Trennwände vorgesehen ist. Bei dem Substrat handelt es sich vorzugsweise um eine Endlosfolie. Durch die Messung der optischen Eigenschaften, wie die Messung der Reflexion, der Transmission etc. des Substrats zwischen den einzelnen Beschichtungskammern ist es möglich, Messungen innerhalb von nur teilweise vollendeten Schichtsystemen vorzunehmen. Hierdurch ergeben sich Vorteile für die prozesstechnische Steuerung des Beschichtungsvorgangs.

Der mit der Erfindung erzielte Vorteil besteht insbesondere darin, die Prozesskontrolle zu verbessern. Bei komplexen optischen Schichtsystemen ist es möglich, nach der ersten, zweiten, dritten usw. Schicht die Reflexion eines Teil-Schichtsystems zu messen. Dies ermöglicht direkte Rückschlüsse auf die Qualität der Schichtdicke der bis zum Messzeitpunkt aufgetragenen Schicht.

Ein Ausführungsbeispiel der Erfindung ist in den Zeichnungen dargestellt und wird im Folgenden näher beschrieben. Es zeigen:
Fig. 1 eine geschnittene Ansicht von der Seite auf eine Beschichtungsanlage für Bänder oder Folien;
Fig. 2 einen Schnitt durch eine Trennwand, in der sich ein Messkopf befindet;
Fig. 3 einen in einer Trennwand verlegten Lichtleiter.

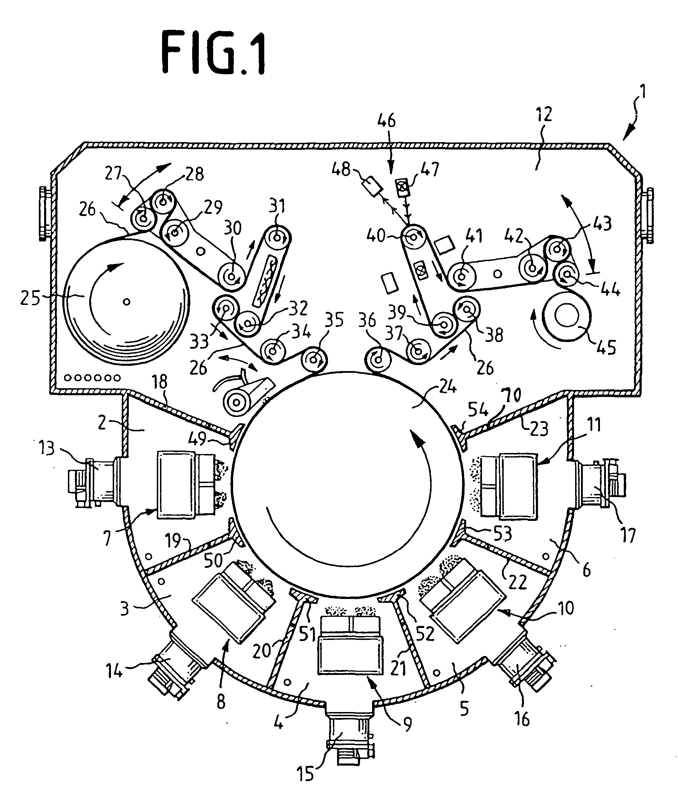

Die Fig. 1 zeigt eine Beschichtungsanordnung 1 für Bänder oder Folien. Diese Beschichtungsanordnung 1 weist mehrere Beschichtungskammern 2, 3, 4, 5, 6 auf, in denen sich jeweils eine Sputtervorrichtung 7, 8, 9, 10, 11 befindet. Außer den Beschichtungskammern 2 bis 6 weist die Beschichtungsanlage 1 noch eine Ab- und Aufwickelkammer 12 auf. Jede der Beschichtungskammern 2 bis 6 ist mit einer Pumpe 13 bis 17 versehen, die in den Beschichtungskammern 2 bis 6 ein Vakuum erzeugt. Zwischen den einzelnen Beschichtungskammern 2 bis 6 und zur Ab- und Aufwickelkammer 12 sind Trennwände 18 bis 23 vorgesehen, die dicht vor einer Beschichtungstrommel 24 enden. Die Rotationsachse der Beschichtungstrommel 24 führt in die Zeichenebene hinein, d. h. die Ab- und Aufwickelkammer befindet sich oben, während sich die Beschichtungskammern 2 bis 6 unten befinden.

In der Ab- und Aufwickelkammer 12 befindet sich eine Walze 25, von der eine zu beschichtende Folie 26 abgewickelt wird. Diese Folie gelangt über mehrere kleine Spann- und Führungswalzen 27 bis 35 auf die Oberfläche der Beschichtungstrommel 24. Nachdem die Folie 26 die Beschichtungstrommel 24 umlaufen hat, wird sie über weitere Walzen 36 bis 44 auf eine Aufwickelwalze 45 aufgewickelt. In der Nähe der Walze 40 befindet sich ein Reflexionsmessgerät 46, das eine Lichtquelle 47 und einen Sensor 48 enthält.

Die Trennwände 18 bis 23 sind in der Nähe der Beschichtungstrommel 24 mit jeweils einem verbreiterten Fuß 49 bis 54 versehen, dessen äußere Kontur an die kreisförmige Kontur der Beschichtungstrommel 24 angepasst ist. In diesen Füßen 49 bis 54 befindet sich jeweils ein Reflexionsmesskopf, der in der Fig. 1 nicht dargestellt ist.

Wird die Folie 26 um die Beschichtungstrommel 24 bewegt, kann sie in jeder Beschichtungskammer 2 bis 6 mit einer eigenen Schicht versehen werden, die vorzugsweise durch Sputtern aufgebracht wird. Die optischen Eigenschaften der unbeschichteten oder beschichteten Folie 26 können somit an jedem Übergang von einer Kammer zur nächsten gemessen werden.

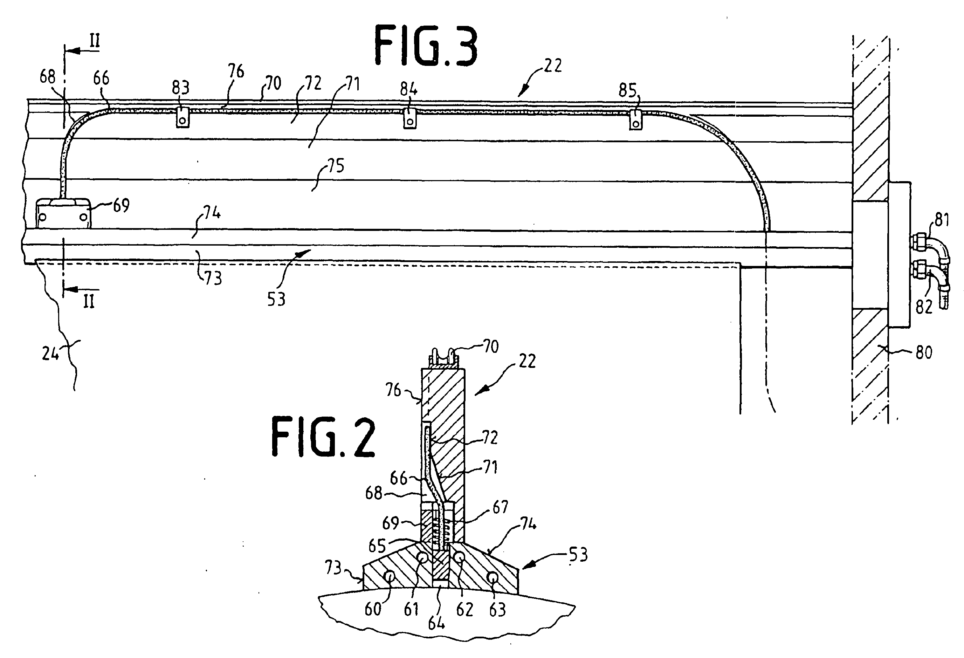

In der Fig. 2 ist der Fuß 53 der Trennwand 22 näher dargestellt. Man erkennt hierbei, dass der Fuß 53 mehreren Bohrungen 60 bis 63 aufweist, durch die ein Kühlmedium strömen kann. Außerdem ist in der Mitte des Fußes 53 eine Bohrung 64 vorgesehen, in der sich ein Reflexionsmesskopf 65 befindet. Dieser Reflexionsmesskopf 65 enthält ein Reflexionsmessgerät, das im Wesentlichen dem Reflexionsmessgerät 46 gemäß Fig. 1 entspricht. Er ist jedoch mit einem Kabelstrang 66 verbunden, um deren unteren Bereich eine Spiralfeder 67 geschlungen ist. In der Trennwand 22 ist eine seitliche Ausnehmung 68 vorgesehen, in welcher der Kabelstrang 66 verläuft. Der Kabelstrang 66 enthält zwei Glasfaserbündel. Das eine Glasfaserbündel dient zur Lichtzuführung auf das beschichtete Substrat, während das andere das reflektierte Licht aufnimmt. Das aufgenommene Licht wird auf einen außerhalb der Anlage befindlichen Empfänger geworfen, der ein elektrisches Signal erzeugt, das an eine zentrale Auswertestelle weiter geleitet wird.

An eine schräg verlaufende Fläche 71 schließt eine senkrecht verlaufende Fläche 72 an. Eine Dichtung 70 schließt den unteren Teil der Trennwand 22 ab.

Die Fig. 3 zeigt einen Blick senkrecht zur Darstellung der Fig. 1 und 2.

Die Beschichtungstrommel 24 bzw. ihre Drehachse verlaufen hierbei horizontal. Über der Beschichtungstrommel 24 befindet sich der Fuß 53 mit seinem vertikal verlaufenden Seitenteil 73 und dem hieran anschließenden schräg verlaufenden Teil 74. Auf diesem Fuß 53 ruht das Gehäuse 69 des Reflexionsmesskopfs 65. Der Kabelstrang 66 verläuft zunächst in der Ausnehmung 68 und ist dann parallel zur Dichtung 70 geführt, um anschließend durch eine Kammeraußenwand 80 nach außen geführt zu werden. In dieser Kammeraußenwand befinden sich Kühlwasserzu- und -abläufe. Der Kabelstrang 66 ist mittels Halterungen 83, 84, 85 im oberen Bereich der Trennwand 22 gehalten.

## Patentansprüche

1. Beschichtungsanlage (1) zum Beschichten eines Substrats (26), mit
1.1 mehreren hintereinander angeordneten Beschichtungskammern (2 - 6),
1.2 Trennwänden (18 - 23) zwischen den Beschichtungskammern (2 - 6), wobei das jeweils freie Ende (49 - 54) der Trennwände (18 - 23) dicht über dem Substrat (26) angeordnet ist, das von einer Beschichtungskammer (z. B. 2) in die nächste Beschichtungskammer (z. B. 3) transportiert wird,
1.3 einer Messvorrichtung (65, 66, 67) für die Messung von optischen Eigenschaften von beschichteten Substraten,
**dadurch gekennzeichnet, dass** die Messvorrichtung (65 - 67) jeweils an den freien Enden (49 - 54) der Trennwände (18 - 23) vorgesehen ist.

2. Beschichtungsanlage nach Anspruch 1, **dadurch gekennzeichnet, dass** die Messvorrichtung (65 - 67) jeweils in das freie Ende (49 - 54) der Trennwände (18 - 23) integriert ist.

3. Beschichtungsanlage nach Anspruch 1, **dadurch gekennzeichnet, dass** die von der Messvorrichtung (65 - 67) gemessenen optischen Eigenschaften Reflexionen sind.

4. Beschichtungsanlage nach Anspruch 1, **dadurch gekennzeichnet, dass** die Messvorrichtung (65 - 67) einen Reflexionsmesskopf (65) enthält.

5. Beschichtungsanlage nach Anspruch 4, **dadurch gekennzeichnet, dass** die Trennwände (18-23) jeweils einen Kabelstrang (66) enthalten, der zwei Glasfaserbündel enthält, wobei der Reflexionsmesskopf (65) mit dem Kabelstrang (66) verbunden ist.

6. Beschichtungsanlage nach Anspruch 5, **dadurch gekennzeichnet, dass** der Kabelstrang (66) entlang der Trennwand (80) geführt ist.

7. Beschichtungsanlage nach Anspruch 6, **dadurch gekennzeichnet, dass** die Beschichtungsanlage (1) einen lichtelektrischen Wandler und eine Auswerteeinrichtung enthält, wobei der Kabelstrang (66) aus der Beschichtungskammer (2 - 6) herausgeführt und über den lichtelektrischen Wandler der Auswerteeinrichtung zugeführt ist.

8. Beschichtungsanlage nach Anspruch 1, **dadurch gekennzeichnet, dass** sie eine Auf- und Abwickelkammer (12) aufweist.

9. Beschichtungsanlage nach Anspruch 8, **dadurch gekennzeichnet, dass** sie eine Beschichtungstrommel (24) aufweist, die zwischen der Auf- und Abwickelkammer (12) und den Beschichtungskammern (2 - 6) angeordnet ist.

10. Beschichtungsanlage nach Anspruch 9, **dadurch gekennzeichnet, dass** die Beschichtungskammern (2 - 6) kreisförmig um die Beschichtungstrommel (24) herum angeordnet sind.

11. Beschichtungsanlage nach Anspruch 1, **dadurch gekennzeichnet, dass** das Substrat eine flexible Folie (26) ist.

12. Beschichtungsanlage nach Anspruch 8, **dadurch gekennzeichnet, dass** in der Ab- und Aufwickelkammer (12) eine weitere optische Messeinrichtung (47, 48) vorgesehen ist.

## Claims

1. Coating installation (1) for coating of a substrate (26), comprising
1.1 a plurality of sequentially disposed coating chambers (2 - 6),
1.2 partitioning walls (18 - 23) between said coating chambers (2 - 6), whereby the free ends (49 - 54) of the partitioning walls (18 - 23) are respectively disposed closely above the substrate (26), said substrate (26) being transported from one coating chamber (e.g. 2) to the next coating chamber (e.g. 3),
1.3 a measuring device (65, 66, 67) for measuring the optical properties of coated substrates,
**characterized in that** the measuring device (65 - 67) is provided at the free end (49 - 54) of the partitioning walls (18 - 23) respectively.

2. Coating installation as claimed in claim 1, **characterized in that** the measuring device (65 - 67) is integrated into the free end (49 - 54) of the partitioning walls (18 - 23) respectively.

3. Coating installation as claimed in claim 1, **characterized in that** the optical properties measured by measuring device (65 - 67) are the reflections.

4. Coating installation as claimed in claim 1, **characterized in that** the measuring device (65 - 67) includes a reflection measuring head (65).

5. Coating installation as claimed in claim 4, **characterized in that** the partitioning walls (18 - 23) include a harness of cables (66) respectively, said harness of cables (66) including two fiber optic bundles, whereby the reflection measuring head (65) is connected with the harness of cables (66).

6. Coating installation as claimed in claim 5, **characterized in that** the harness of cables (66) is guided along the partitioning wall (80).

7. Coating installation as claimed in claim 6, **characterized in that** the coating installation (1) includes an optoelectric converter and an evaluation unit, whereby the harness of cables (66) is brought out of the coating chamber (2 - 6) and supplied via the optoelectric converter to the evaluation unit.

8. Coating installation as claimed in claim 1, **characterized in that** it comprises a wind-up and feed-out chamber (12).

9. Coating installation as claimed in claim 8, **characterized in that** it comprises a coating drum (24), disposed between the wind-up and feed-out chamber (12) and the coating chambers (2 - 6).

10. Coating installation as claimed in claim 9, **characterized in that** the coating chambers (2 - 6) are disposed circularly around the coating drum (24).

11. Coating installation as claimed in claim 1, **characterized in that** the substrate is a flexible film (26).

12. Coating installation as claimed in claim 8, **characterized in that** in the feed-out and wind-up chamber (12) a further optical measuring unit (47, 48) is provided.

## Revendications

1. Installation (1) pour le revêtement d'un substrat (26) avec
1.1 plusieurs chambres de revêtement (2 - 6) disposées les unes derrière les autres,
1.2 des cloisons de séparation (18 - 23) entre les chambres de revêtement (2 - 6), l'extrémité libre respective (49 - 54) des cloisons (18 - 23) étant disposée de manière étanche au-dessus du substrat (26) qui est transporté de la chambre de revêtement (par exemple 2) à la chambre de revêtement (par ex. 3),
1.3 un dispositif de mesure (65, 66, 67) pour la mesure de propriétés optiques de substrats revêtus,
**caractérisé en ce que** le dispositif de mesure (65 - 67) est prévu respectivement aux extrémités libres (49 - 54) des cloisons (18 - 23).

2. Installation de revêtement selon la revendication 1, **caractérisé en ce que** le dispositif de mesure (65 - 67) est intégré respectivement dans l'extrémité libre (49 - 54) des cloisons (18 - 23).

3. Installation de revêtement selon la revendication 1, **caractérisé en ce que** les propriétés optiques mesurées par le dispositif de mesure (65 - 67) sont des réflexions.

4. Installation de revêtement selon la revendication 1, **caractérisé en ce que** le dispositif de mesure (65 - 67) comporte une tête de réflexion (65).

5. Installation de revêtement selon la revendication 4, **caractérisé en ce que** les cloisons (18 - 23) contiennent respectivement un brin de câble (66) qui comporte deux faisceaux de fibres optiques, la tête de mesure (65) étant reliée au brin de câble (66).

6. Installation de revêtement selon la revendication 5, **caractérisée en ce que** le brin de câble (66) est guidé le long de la cloison (80).

7. Installation de revêtement selon la revendication 6, **caractérisé en ce que** l'installation de revêtement (1) comporte un transformateur photoélectrique et un dispositif d'analyse, le brin de câble (66) étant guidé hors de la chambre de revêtement (2 - 6) et étant amené au dispositif d'évaluation par le transformateur photoélectrique.

8. Installation de revêtement selon la revendication 1, **caractérisé en ce qu'**elle présente une chambre d'enroulement et de déroulement (12).

9. Installation de revêtement selon la revendication 8, **caractérisé en ce qu'**elle présente un tambour de revêtement (24) qui est disposé entre la chambre d'enroulement et de déroulement (12) et les chambres de revêtement (2-6).

10. Installation de revêtement selon la revendication 9, **caractérisé en ce que** les chambres de revêtement (2 -6) sont disposées en forme de cercle autour du tambour de revêtement (24).

11. Installation de revêtement selon la revendication 1, **caractérisé en ce que** le substrat est une feuille flexible (26).

12. Installation de revêtement selon la revendication 8, **caractérisé en ce que** dans la chambre de déroulement et d'enroulement (12), il est prévu un autre dispositif de mesure optique (47, 48).
